# EUROPEAN PATENT SPECIFICATION

(11) **EP 4 385 010 B1**
(45) Date of publication and mention of the grant of the patent: **02.12.2026**
(21) Application number: 22854818.6
(22) Date of filing: 05.08.2022
(51) Int. Cl.: G10L 19/00, G10L 19/005, H03G 3/30, H03G 11/08, G10L 19/26

(54) **METHOD AND DEVICE FOR LIMITING OF OUTPUT SYNTHESIS DISTORTION IN A SOUND CODEC**
VERFAHREN UND VORRICHTUNG ZUR BEGRENZUNG DER AUSGANGSSYNTHESEVERZERRUNG IN EINEM TON-CODEC
PROCÉDÉ ET DISPOSITIF DE LIMITATION DE DISTORSION DE SYNTHÈSE DE SORTIE DANS UN CODEC SONORE

(30) Priority: 10.08.2021 US 202163231539 P
(43) Date of publication of application: 19.06.2024
(73) Proprietor: VoiceAge Corporation, Town of Mount Royal, Quebec H3R 2H6 (CA)
(72) Inventor: EKSLER, Vaclav, Oslavou (CZ)
(74) Representative: Bosch Jehle Patentanwaltsgesellschaft mbH
(86) International application number: PCT/CA2022/051199
(87) International publication number: WO 2023/015375

(56) References cited:
- EP-B1- 3 108 669
- US-A1- 2013 148 826
- US-B2- 8 254 404
- US-B2- 9 060 236
- LUZHENG LU: "A digital realization of audio dynamic range control", SIGNAL PROCESSING PROCEEDINGS, 1998. ICSP '98. 1998 FOURTH INTERNATION AL CONFERENCE ON BEIJING, CHINA 12-16 OCT. 1998, PISCATAWAY, NJ, USA,IEEE, US, vol. 2, 12 October 1998 (1998-10-12), pages 1424 - 1427, XP010336217, ISBN: 978-0-7803-4325-2, DOI: 10.1109/ICOSP.1998.770888

## Description

### TECHNICAL FIELD

The present disclosure relates to sound coding, in particular but not exclusively to a method and device (limiter) for limiting distortion in a sound signal, for example an output sound signal synthesis from a sound signal decoder. If a sound renderer is used, the distortion limiting method and device (limiter) may be implemented after or as part of the renderer.

In the present disclosure and the appended claims:
- The term "sound" may be related to speech, audio and any other sound;
- The term "stereo" is an abbreviation for "stereophonic";
- The term "mono" is an abbreviation for "monophonic"; and
- The term "multi-channel" may be related to two and more sound signals or sound codecs.

### BACKGROUND

Historically, conversational telephony has been implemented with handsets having only one transducer to output sound only to one of the user's ears. In the last decade, users have started to use their portable handset in conjunction with a headphone to receive the sound over their two ears mainly to listen to music but also, sometimes, to listen to speech. Nevertheless, when a portable handset is used to transmit and receive conversational speech, the content is still mono but presented to the user's two ears when a headphone is used.

With the newest 3GPP (3rd Generation Partnership Project) speech coding Standard, designated Enhanced Voice Services (EVS), as described in Reference [1], the quality of the coded sound, for example speech and/or audio that is transmitted and received through a portable handset, has been significantly improved. The next natural step is to transmit stereo information such that the receiver gets as close as possible to a real-life audio scene that is captured at the other end of the communication link.

Efficient stereo coding techniques have been developed and used for low bit-rates. As a non-limitative example, the so-called parametric stereo coding constitutes one efficient technique for low bit-rate stereo coding. Parametric stereo encodes two, left and right channels as a mono signal using a common mono codec plus a certain amount of stereo side information (corresponding to stereo parameters) which represents a stereo image. The two input, left and right channels are down-mixed into a mono signal, for example by summing the left and right channels and dividing the sum by 2. The stereo parameters are then computed usually in transform domain, for example in the Discrete Fourier Transform (DFT) domain, and are related to so-called binaural or inter-channel cues. The binaural cues may comprise Interaural Level Difference (ILD), Interaural Time Difference (ITD) and Interaural Correlation (IC). Depending on the signal characteristics, stereo scene configuration, etc., some or all binaural cues are coded and transmitted to the decoder.

Further, in last years, the generation, recording, representation, coding, transmission, and reproduction of audio is moving towards an enhanced, interactive and immersive experience for the listener. The immersive experience can be described, for example, as a state of being deeply engaged or involved in a sound scene while sounds are coming from all directions. In immersive audio (also called 3D (Three-Dimensional) audio), the sound image is reproduced in all three dimensions around the listener, taking into consideration a wide range of sound characteristics like timbre, directivity, reverberation, transparency and accuracy of (auditory) spaciousness. Immersive audio is produced for a particular sound playback or reproduction system such as a loudspeaker-based system, an integrated reproduction system (sound bar), or headphones. Then, interactivity of a sound reproduction system may include, for example, an ability to adjust sound levels, change positions of sounds, or select different languages for the reproduction.

In recent years, 3GPP (3^{rd} Generation Partnership Project) started working on developing a 3D sound codec for immersive services called IVAS (Immersive Voice and Audio Services), based on the EVS codec (See Reference [2]).

In sound codecs, the output sound signal may be corrupted by several types of distortion.

Distortion may be caused by clippings where samples of sound signal have a value higher or lower than a certain threshold. This situation can typically happen when a sample of sound signal a) is converted from a floating-point representation to a fixed-point representation, b) is converted from one fixed-point representation to another fixed-point representation with a shorter bit length (e. g. from *long integer* to *short integer* (e. g. in C99 programming language standard as described in Reference [3], *Long signed integer* type is capable of containing the [-2,147,483,647, +2,147,483,647] 32- bit range while *Short signed integer type* is capable of containing the [-32,767, +32,767] 16-bit range), c) as a result of an instability in the decoding algorithm of the sound codec, d) during rendering when a sound (voice and/or audio) signal is manipulated, down-mixed etc. When one of these situations occurs, the amplitude of the sound signal samples can saturate and it is thus clipped, or limited, resulting in a perceptually annoying sound.

In order to reduce such clippings, Automatic Gain Control (AGC) as implemented in the ACELP core of the mono EVS codec (Reference [1]) can be used. The AGC is a closed-loop feedback algorithm regulating and maintaining the varying amplitude of sound signal samples within limits suitable for processing of these sound signal samples without distortion. AGC is designed to regulate sound signal samples in time domain with no additional delay.

The problem of saturation is even more challenging in multi-channel codecs, typically when the number of decoded channels is higher than the number of output channels, or the decoded channels are correlated. An example is the rendering of decoded multi-channel audio to a binaural output.

Saturation often occurs also as a consequence of an instability in the decoding algorithm, for example when the long-term synthesis filter used in a CELP-based sound codec is unstable or when a received bitstream is corrupted by frame erasures or bit errors.

### SUMMARY

The present disclosure relates to a method and device (limiter) for limiting distortion in a sound signal. When a sound renderer is implemented following a sound signal decoder, the method and device (limiter) for limiting distortion in the sound signal may be performed on the rendered sound signal.

According to a first aspect, the present disclosure relates to a two-stage method for limiting distortion in a sound signal, comprising, in a first stage, detecting an amplitude value of the sound signal and computing a control gain using the detected amplitude value, attenuating the level of the sound signal using the control gain and, in a second stage, detecting saturation in the sound signal and updating the control gain in response to detection of saturation.

According to a second aspect, the present disclosure relates to a two-stage method for limiting distortion in an output sound signal synthesis from a sound signal decoder. In a first stage, an amplitude value of the output sound signal synthesis is detected, a control gain is computed using the detected amplitude value, and the level of the output sound signal synthesis is attenuated using the control gain. In a second stage, saturation in the output sound signal synthesis is detected and the control gain is updated in response to detection of saturation.

According to another aspect, there is provided a two-stage distortion limiter for limiting distortion in a sound signal, comprising (a) a first stage comprising a level detector for detecting an amplitude value of the sound signal and for computing a control gain using the detected amplitude value, and an attenuator of the level of the sound signal using the control gain, and (b) a second stage comprising a saturation detector for detecting saturation in the sound signal and for updating the control gain in response to detection of saturation.

According to a further aspect, there is provided a two-stage distortion limiter for limiting distortion in an output sound signal synthesis from a sound signal decoder, comprising (a) a first stage comprising a level detector for detecting an amplitude value of the output sound signal synthesis and for computing a control gain using the detected amplitude value, and an attenuator of the level of the output sound signal synthesis using the control gain; and (b) a second stage comprising a saturation detector for detecting saturation in the output sound signal synthesis and for updating the control gain in response to detection of saturation.

The foregoing and other features will become more apparent upon reading of the following non-restrictive description of an illustrative embodiment of the two-stage distortion limiter and distortion limiting method, given by way of example only with reference to the accompanying drawings.

### BRIEF DESCRIPTION OF THE DRAWINGS

In the appended drawings:
Figure 1 is a schematic block diagram illustrating concurrently an example implementation of a one-stage multi-channel distortion limiter, and a corresponding distortion limiting method;
Figure 2 is a schematic block diagram of a two-stage multi-channel distortion limiter, and a corresponding distortion limiting method;
Figure 3 is a schematic block diagram illustrating concurrently a saturation detector forming part of the device of Figure 2, and a corresponding saturation detecting method;
Figure 4 is an illustration showing the impact of the two-stage distortion limiter and distortion limiting method on the output sound signal synthesis; and
Figure 5 is a simplified block diagram of an example configuration of hardware components implementing the distortion limiter and distortion limiting method.

### DETAILED DESCRIPTION

The present disclosure is concerned with limitation of distortion in an output sound signal synthesis from the sound signal decoder of a sound codec. As indicated earlier in the present disclosure, if a sound renderer is implemented following the sound signal decoder, the method and device (limiter) for limiting distortion in the output sound signal synthesis from the sound signal decoder may be performed on the rendered sound signal. Distortion may happen as a consequence of an unstable decoding process. In particular, the present disclosure introduces a second-stage algorithm in the distortion limiter and distortion limiting method for detecting and limiting distortion caused for example by a) bitstreams with bit errors or other types of corrupted bitstreams, and b) saturations in general. The distortion limiter can be implemented in a mono, stereo, or multi-channel sound signal decoder for example just before the final float to integer conversion, or before *long integer* to *short integer* conversion. When the distortion limiter detects distortion such as saturation, an attenuation is applied which results in a much more pleasant output sound signal synthesis.

An example of simple distortion limiter and distortion limiting method involving saturation control is the so-called Automatic Gain Control (AGC) applied in the EVS codec to the decoded sound signal at the internal sampling rate. AGC as used in the EVS codec is described in Reference [1]. The AGC algorithm consists of two steps. First, a frame factor *β*₁ is computed using relations (1) and (2): ${β}_{1} = \left\{\begin{matrix}0.5 - \frac{15 , 000}{{s}_{max}} , & if {s}_{max} > 30 , 000 \\ 0 , & otherwise ,\end{matrix}\right.$ (1) ${s}_{max} = max \left[abs\left(s\left(n\right)\right)\right] , n = 0 , … , N - 1 ,$ (2) where *s(n), n* = 0, ... , N-1, is the deemphasized sound signal synthesis at the internal sampling rate, and N is the frame length in samples.

Then, the frame factor *β*₁ is used to update a long-term AGC factor *β*₂ using relation (3): ${β}_{2} \left(n\right) = 0.99 ⋅ {β}_{2} \left(n-1\right) + 0.01 ⋅ {β}_{1}$ (3)

Finally, each sample of the output sound signal synthesis is updated using a closed-loop feedback as expressed in relation (4): $s ′ \left(n\right) = \left(1-{β}_{2}\left(n\right)\right) ⋅ s \left(n\right) - {β}_{2} \left(n\right) ⋅ s \left(n-1\right) , n = 0 , … , N - 1 ,$ (4)

The above described AGC limiter was adopted in several recent speech and audio mono coding standards, such as EVS. For stereo and multi-channel codecs, more elaborated distortion limiter and distortion limiting method are implemented. In the present disclosure, the distortion limiter and corresponding distortion limiting method is implemented by way of example in a 3D sound coding framework, i.e. in the IVAS framework.

### 1. Distortion Limiter in Multi-Channel Codecs

In a multi-channel codec such as IVAS outlined in Reference [2], distortion such as saturations may occur in one, several, or all output channels. The attenuation can then be applied to all output channels regardless if any of them originally contains saturations or not in order to preserve the spatial characteristics of the output sound such as audio/speech.

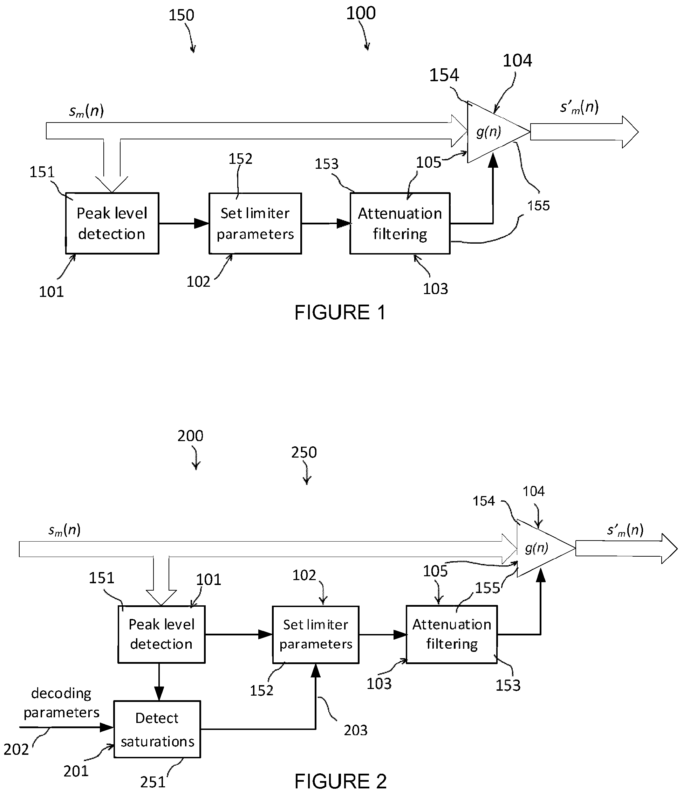

An example implementation of a distortion limiter in a multi-channel codec can be a general non-specific digital limiter, for example the audio dynamic range controller with variable parameters as described in Reference [4]. Any other distortion limiter can be used without departing from the scope of the present disclosure. In the following description, distortion level limitation is used and comprises generating a control gain and using a first order IIR (Infinite Impulse Response) filter for attack and release time processing. Figure 1 is a schematic block diagram illustrating concurrently such an example implementation of one-stage multi-channel distortion limiter and corresponding distortion limiting method.

The distortion limiting method and device (limiter) can be used in several parts of the sound coding, decoding and/or reproduction system, e.g. in a pre-renderer at the coding end, as part of the decoder, after the decoder, as part of the sound renderer, or after the sound renderer just before outputting sound signals from the system. For the purpose of simplifying the description, but without restricting the scope of the present disclosure, the terms used in the present disclosure focus on the implementation of the distortion limiting method and device (limiter) after the sound renderer.

Referring to Figure 1, the example implementation of one-stage multi-channel distortion limiting method 100 comprises an operation 101 of output sound signal synthesis level detection, an operation 102 of setting limiter parameters, and an operation 105 of attenuation filtering that can be split, as illustrated in Figure 1, into a "gain filtering" sub-operation 103 as described for example by relation (7) and a "gain-applying" sub-operation 104 as described for example by relation (8).
*sₘ*(*n*) (which is the sound signal to be distortion limited in the example implementation of Figure 1) is the m-th channel of the output sound signal synthesis (for example speech and/or audio), where m = 0, ..., *M-1, M* is the number of output channels, n = 0, ..., N-1 is a time sample index, and N is the frame length in samples. As known to those of ordinary skill in the art, the output sound signal synthesis is processed in successive blocks of output sound signal synthesis samples called frames (hereinafter output sound signal synthesis processing frames).

To perform operation 101, the one-stage multi-channel distortion limiter 150 of Figure 1 comprises a level detector 151 to detect an amplitude value of the sound signal synthesis. In the illustrated non-limitative implementation, the level detector is a peak level detector 151 to detect a maximum absolute value p (also called "peak value") of the sound signal synthesis samples of all output channels m of the output sound signal synthesis in the current frame using, for example, relation (5): $p = max \left[abs\left({s}_{m}\left(n\right)\right)\right] , n = 0 , … , N - 1 , m = 0 , … , M - 1 .$ (5)

The peak level detector 151 then uses the detected peak value p to compute a control gain (also called "gate attenuation"), denoted as *g_{c}*. The peak level detector 151 first compares the peak value p with a limiter threshold (also called "gate level") denoted as Ω. If p ≤ Ω, the peak level detector 151 then sets the control gain *g_{c}* = 1. If p > Ω, however, the peak level detector 151 computes the control gain using, for example, relation (6): ${g}_{c} = max \left[{Γ}_{1}, \frac{Ω}{p}\right]$ (6) where the parameter Γ₁ denotes a lowest gain limit, for example Γ₁ = 0.15. Of course, other values of parameter Γ₁ can be implemented. Limiting the control gain *g_{c}* equal to or below Γ₁ is usually not expected and in general cannot happen in stable sound signal decoders, typically sound signal decoders receiving bitstreams not corrupted by bit errors. If gain limiting is not implemented, however, there might happen that a longer segment of output sound signal synthesis is attenuated too strongly (up to close to zero) and thus the sound might become inaudible. For example, in a non-limitative illustrative implementation, if the distortion limiter 150 is intended to limit the output sound signal synthesis to *short integer* values in a range of [-32,768; 32,767], the limiter threshold can be set to Ω = 32, 750.

To perform operation 102, the one-stage multi-channel distortion limiter 150 of Figure 1 comprises a calculator 152 of limiter parameters that are computed to generate the desired dynamic characteristics as taught by Reference [4]. For example, an attack/release time parameter *γ* is computed and is responsible for defining a shorter or longer attack/release time. The attack/release time parameter *γ* provides a control how quickly the distortion limiter acts and can be in general subject to adjustment or tuning during development. In more detail:
- The attack parameter controls the time taken by the distortion limiter to reduce the control gain after the detected peak value of the output sound signal synthesis has exceeded the limiter threshold Ω.
- The release parameter controls the time it takes for the control gain to return to its normal level of 1.0 after the detected peak value of the output sound signal synthesis fell below the limiter threshold Ω.

To perform operation 103, the one-stage multi-channel distortion limiter 150 of Figure 1 comprises an attenuator 155 of the level of the output sound signal synthesis *sₘ*(*n*) comprising a gain filter 153 such as a first order IIR low-pass filter using the attack/release time parameter *γ* to obtain a gain *g(n)* per sample of the output sound signal synthesis. Filter 153 can be described, for example, by relation (7): $g \left(n\right) = γ ⋅ \left[g\left(n-1\right)-{g}_{c}\right] + {g}_{c}$ (7) where *γ* denotes the above-mentioned attack/release time parameter. To perform operation 103, the attenuator 155 of Figure 1 also comprises an amplifier 154 for applying the gain *g(n)* to every n-th sample of all the channels m of the output sound signal synthesis *sₘ*(*n*) to obtain a distortion-limited output sound signal synthesis *s'ₘ*(*n*), using for example relation (8): ${s}_{m}^{′} \left(n\right) = g \left(n\right) ⋅ {s}_{m} \left(n\right) , n = 0 , … , N - 1 , m = 0 , … , M - 1 .$ (8)

While the above described one-stage (first stage) procedure is able to adequately handle common situations in multi-channel codecs, it is not sufficiently performant in situations when the output sound signal synthesis *sₘ*(*n*) is corrupted by a) bitstreams with bit errors or other highly corrupted bitstreams, and b) strong saturations in general. To cope with this deficiency, a second stage is added to the distortion limiter 150 and distortion limiting method 100 to detect and limit saturations.

### 2. Second Stage of Distortion Limiter

Figure 2 is a schematic block diagram of a two-stage multi-channel distortion limiter 250, and corresponding distortion limiting method 200.

Referring to Figure 2, the example implementation of two-stage multi-channel distortion limiting method 200 comprises, as a first stage, the operation 101 of output sound signal synthesis level detection, the operation 102 of setting limiter parameters, and the operation 105 of attenuation filtering including the gain filtering sub-operation 103 and the gain-applying sub-operation 104 as described in relation to Figure 1. In the same manner, the two-stage multi-channel distortion limiter 250 of Figure 2 comprises, as the first stage, the sound signal synthesis level detector such as the peak level detector 151, the calculator 152 of limiter parameters, and the attenuator 155 including the gain filter 153 and the amplifier 154 as also described with reference to Figure 1.

The two-stage multi-channel distortion limiting method 200 comprises, as a second stage, an operation 201 of detecting saturations in the output sound signal synthesis *sₘ*(*n*). The two-stage multi-channel distortion limiter 250 of Figure 2 comprises, as the second stage, a saturation detector 251 for performing operation 201.

The second stage of the two-stage multi-channel distortion limiter 250 and corresponding distortion limiting method 200 are designed for detecting saturations, in particular strong saturations of the output sound signal synthesis *sₘ*(*n*). The term "strong saturations" is intended to designate saturations with an unexpectedly high level, e. g. higher than 1 / Γ₁ times the maximum desired output sound signal level. Although the illustrative implementation refers to detection of strong saturations as defined above, it is within the scope of the present disclosure, in view of improving the output sound signal synthesis, to also detect weaker saturations by adapting the values of the parameters, thresholds, counters, constants, etc., used in the saturation detector 251 and the corresponding saturation detecting method 201 as described herein after.

In the described illustrative implementation, the second stage (saturation detector 251 and saturation detection operation 201) produces an output 203 indicative of (a) a decision if additional attenuation is to be applied to the output sound signal synthesis *sₘ*(*n*) and (b) an extent of the attenuation to be applied to the output sound signal synthesis *sₘ*(*n*) indicated by an updated control gain *g_{c}*.

The second stage cannot only be implemented in the distortion limiter of Figure 1, but also in any other distortion limiter including the above mentioned mono AGC limiter in which case the second stage is used to alter the frame factor *β*₁ from relation (1) and thus the long-term AGC factor *β*₂ from relation (3).

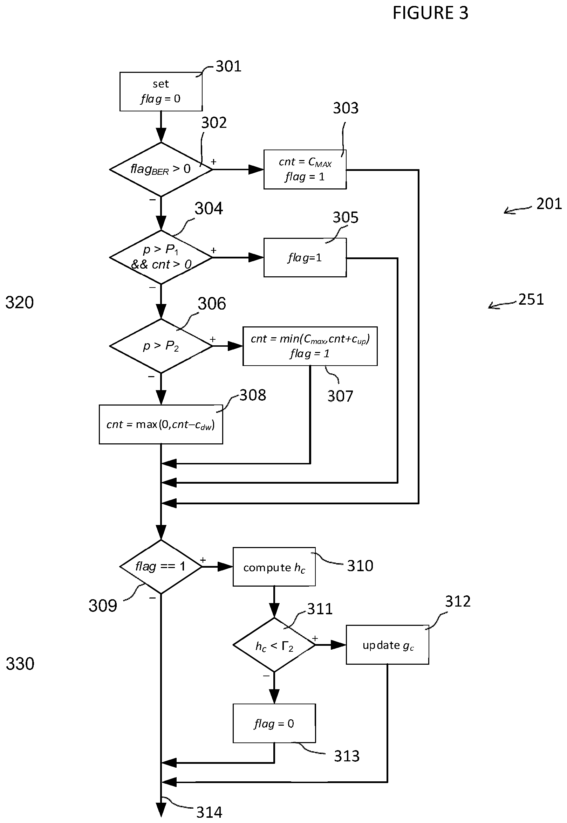

Figure 3 is a schematic block diagram illustrating concurrently the saturation detector 251 and the corresponding saturation detecting method 201 of Figure 2. The saturation detector 251 produces a saturation detection flag *flag* indicating whether saturation was detected or not, and an updated control gain *g_{c}*.

Referring to Figure 3, the saturation detecting operation 201 and the corresponding saturation detector 251 initializes (see 301), at the beginning of every output sound signal synthesis processing frame, the saturation detection flag *flag* to 0. It should be noted that the saturation detector 251 performs saturation detection on each of the M audio channels in every sound signal synthesis processing frame.

The saturation detector 251 and the corresponding saturation detecting method 201 then comprises two parts:
- a first calculator 320 which updates a saturation detection counter *cnt* which stores a metric measuring probability that saturation, in particular strong saturation is present in a current output sound signal synthesis processing frame and produces the saturation detection flag *flag;* and
- a second calculator 330 which, as described herein above, (a) decides if additional attenuation is to be applied to the output sound signal synthesis *sₘ*(*n*) and (b) determines an extent of the attenuation to be applied to the output sound signal synthesis *sₘ*(*n*) by producing an updated control gain *g_{c}*.

The first calculator 320 of the saturation detector 251 and the corresponding saturation detecting method 201 will now be described.

The first calculator 320 of the saturation detector 251 and the corresponding saturation detecting method 201 starts with a decision (see 302) whether bit errors, signalled from the algorithm of the sound signal decoder by a parameter *flag_{BER},* were detected in the received bitstream of the current output sound signal synthesis processing frame or not. If bit errors were detected, indicated by parameter *flag_{BER} ==* 1 (see 302), the saturation detection counter *cnt* is updated to its maximum value *cnt = C_{MAX}* (see 303) and the saturation detection flag *flag* is set to its saturation indicating value *flag =* 1 (see 303). The saturation detection is then continued by the second calculator 330 (starting at 309) of the saturation detector 251 and the corresponding saturation detecting method 201. It should be noted that updating the saturation detection counter *cnt* to its maximum value *C_{MAX}* might be also driven by other decoding parameter(s) 202 (Figure 2) from the sound signal decoder. In the present non-limitative example implementation, *C_{MAX} =* 50. It is noted that the saturation detection counter *cnt* is set to *cnt =* 0 at decoder initialization.

Still referring to Figure 3, if the parameter *flag_{BER} ==* 0 (see 302), indicating that no bit errors are detected in the bitstream received by the sound signal decoder, the saturation detector 251 and the corresponding saturation detecting method 201 continues with a second decision (see 304) using the detected peak value p from relation (5). If the peak value p is greater than a given threshold *P*₁ and the saturation detection counter *cnt >* 0, the saturation detection flag is set to its saturation indicating value *flag =* 1 (see 305). The saturation detection is then continued in the second calculator 330 (starting at 309) of the saturation detector 251 and the corresponding saturation detecting method 201. In the present non-limitative example implementation, *P*₁ = 3·Ω where Ω is the limiter threshold from relation (6).

If (a) the parameter *flag_{BER} ==* 0 (see 302), indicating that no bit errors are detected in the bitstream received by the sound signal decoder, (b) the peak value p is equal to or lower (not larger) than the threshold *P*₁ and/or the saturation detection counter *cnt =* 0 (see 304), the first calculator 320 of the saturation detector 251 and the corresponding saturation detecting method 201 continues with a third decision (see 306) whether the peak value p is greater than a given threshold *P*₂. For the purpose of decision 306, the saturation detection counter *cnt* is not used to try to detect instabilities of the sound signal decoder other than that caused by bit errors. If p > *P*₂ (see 306), the saturation detection counter *cnt* is updated to the minimum between *C_{MAX}* and the sum of *cnt + cᵤₚ* (it is ensured that the *cnt* value does not exceed the maximum value *C_{MAX}*) and the saturation detection flag is set to *flag =* 1 (see 307). In the present non-limitative example implementation *P*₂ = 10·Ω (where Ω is the limiter threshold from relation (6)) and the constant *cᵤₚ* = 20 represents an incrementation step up. The saturation detection then continues in the second calculator 330 (starting at 309) of the saturation detector 251 and the corresponding saturation detecting method 201.

If the parameter *flag_{BER} ==* 0 (see 302), indicating that no bit errors are detected in the bitstream received by the sound signal decoder, (b) the peak value p is equal to or lower (not larger) than the threshold *P*₁ and/or the saturation detection counter *cnt =* 0 (see 304), and (c) the peak value p is equal to or lower (not larger) than the threshold *P*₂ (see 306), the first calculator 320 updates the saturation detection counter *cnt* (see 308) to the maximum between 0 and the difference *cnt - c_{dw}* (it is ensured that the minimum value of the detection counter *cnt* is 0). In the present non-limitative example implementation, the constant *c_{dw} =* 1 represents an incrementation step down. The saturation detection then continues in the second calculator 330 (starting at 309) of the saturation detector 251 and the corresponding saturation detecting method 201.

At this point, the contribution of the first calculator 320 of the saturation detector 251 and the saturation detecting method 201 is completed. As can be appreciated, the first calculator 320 takes into consideration a plurality of factors, including bit errors in the bitstream (parameter *flag_{BER}*), two thresholds *P*₁ and *P*₂ applied to the detected peak value p, and the updated counter *cnt* for an accurate determination of the saturation detection indicating value "1" or no saturation detection indicating value "0" of the flag *flag.*

In the second calculator 330 of the saturation detector 251 and the corresponding saturation detecting method 201, if the saturation detection flag *flag* is equal to 0 (see 309), the saturation detecting method 201 is ended and no additional attenuation is requested at the output 314 (corresponding to 203 in Figure 2) of the second stage of the two-stage multi-channel distortion limiter 250.

On the other hand, if the saturation detection flag *flag =* 1 (see 309), the second calculator 330 of the saturation detector 251 and the corresponding saturation detecting method 201 computes (see 310) a gain correction factor *h_{c}* using, for example, relation (9): ${h}_{c} = \frac{Ω}{p}$ (9) where Ω is the above defined limiter threshold and p the above defined peak value.

If the gain correction factor *h_{c}* is lower than a certain, for example experimentally found threshold Γ₂, for example Γ₂ = 0.3, (see 311), the second calculator 330 updates (see 312) the control gain *g_{c}* from relation (6) using, for example, relation (10): ${g}_{c} = \frac{{h}_{c}}{α}$ (10) where α is an additional correction factor. In the present, non limitative example implementation α = 3.0.

Otherwise, if *h_{c}* ≥ Γ₂ (see 311), the second calculator 330 sets the saturation detection flag to *flag* = 0 (see 313) and performs no updating of the control gain *g_{c}*.

The function of the threshold Γ₂ is to update the gain correction factor *h_{c}* only when it is adequately low. Also, the function of the additional correction factor α is to control the strength of the additional limitation of the control gain *g_{c}* (see relation (10)).

The second calculator 330 of the saturation detector 251 and the corresponding saturation detecting method 201 thus ends with possible update of the control gain *g_{c}* which the two-stage multi-channel distortion limiter 250 then takes into account. Moreover, if the saturation detector 251 updates (see 312) the control gain *g_{c}*, it holds the saturation detection flag to the value *flag =* 1 at the output 314 and the parameter Γ₁ in relation (6) is set to 0. Thus relation (6) used in the peak level detector 151 of the first stage of the two-stage multi-channel distortion limiter 250 is changed, for example, to relation (11): ${g}_{c} = \frac{Ω}{α ⋅ p}$ (11)

In the source code, as used in the IVAS framework, the two-stage multi-channel distortion limiter 250 and corresponding distortion limiting method 200 could be implemented as follows:

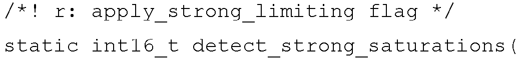

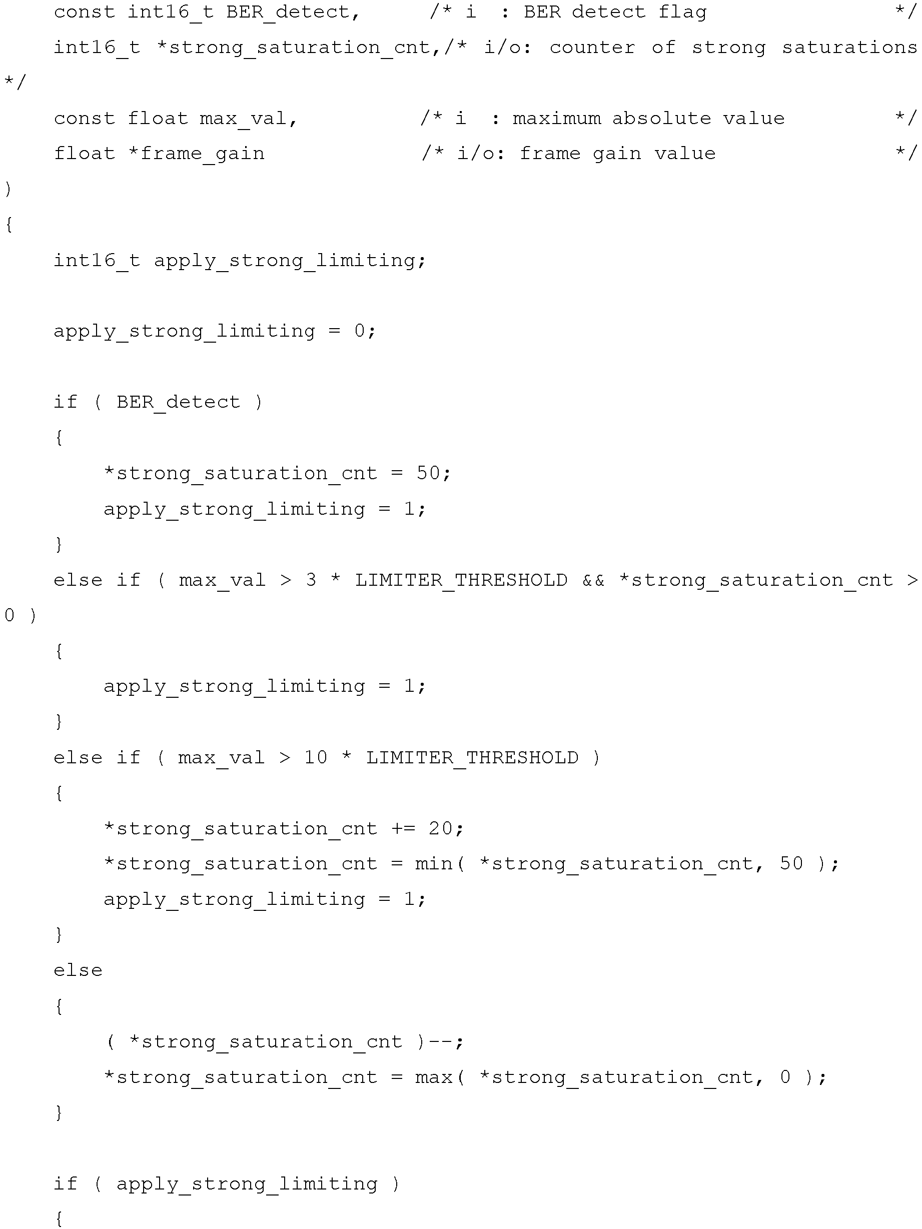

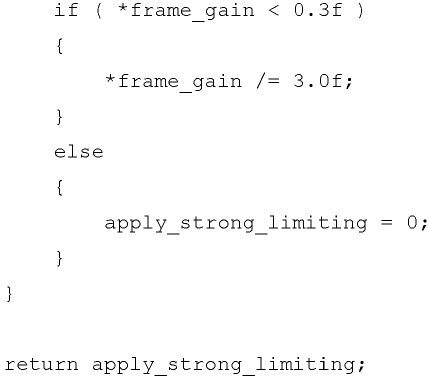

### 3. Performance

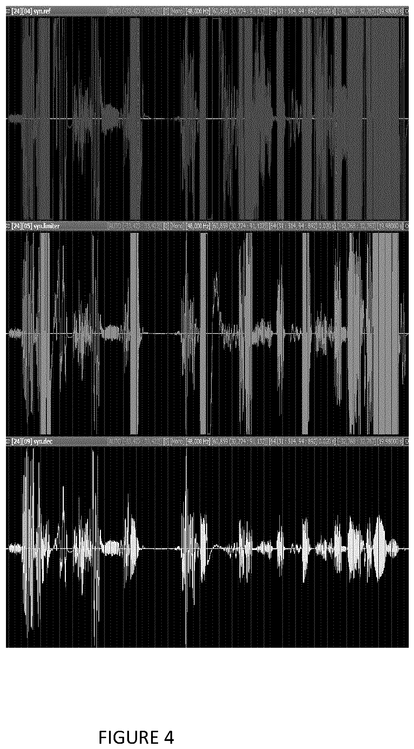

Figure 4 is an illustration showing the impact of the distortion limiter 250 and distortion limiting method 200 on the output sound signal synthesis, in the non limitative example when a bitstream corrupted by bit errors is received by an EVS sound signal decoder.

From Figure 4, it is noted that the output sound signal synthesis is very distorted when no distortion limiter is used (top graph of Figure 4). The number of distortions, or energy overshoots, is reduced when a one-stage distortion limiter as illustrated in Figure 1 is used (middle graph of Figure 4) and further significantly reduced when a two-stage distortion limiter as illustrated in Figure 2 is employed (bottom graph of Figure 4).

For illustration, an example of number of clippings in a 40 seconds long sound signal synthesis is shown below:

| *variant* | *number of clippings* |
|---|---|
| No limiter | 184,685 |
| One-stage limiter | 55,725 |
| Two-stage limiter | 131 |

### 4. Implementation variants

The present disclosure is presented in a context of a codec implemented in the floating-point arithmetic. When implemented in the fixed-point arithmetic with a limited data-type length, some logic described above could not properly work and would need to be tuned. As an example, instead of comparing the peak value p against thresholds *P*₁ and *P*₂ in the first part of the saturation detector 251 and the corresponding saturation detecting method 201, it is possible to introduce a different logic. An example could be a logic based on a counter of number of clippings (output sound signal synthesis before the distortion limiter has sample values equal to maximum or minimum value of the fixed-point data-type resolution) and/or number of zero crossings.

### 5. Hardware implementation

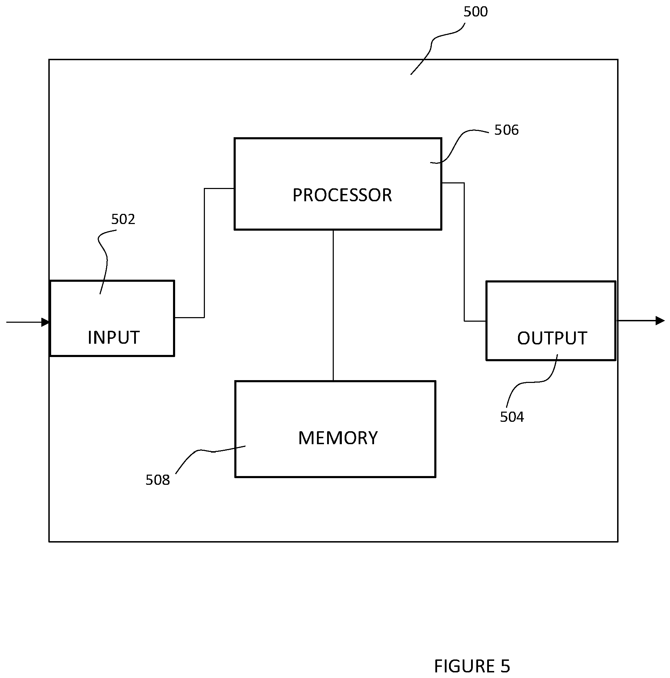

Figure 5 is a simplified block diagram of an example configuration of hardware components forming the above described distortion limiter and distortion limiting method.

The distortion limiter may be implemented as a part of a mobile terminal, as a part of a portable media player, an audio format converter or any similar device. The distortion limiter (identified as 500 in Figure 5) comprises an input 502, an output 504, a processor 506 and a memory 508.

The input 502 is configured to receive the input sound signal synthesis, in digital or analog form. The output 504 is configured to supply the output, distortion limited sound signal synthesis. The input 502 and the output 504 may be implemented in a common module, for example a serial input/output device.

The processor 506 is operatively connected to the input 502, to the output 504, and to the memory 508. The processor 506 is realized as one or more processors for executing code instructions in support of the functions of the various components of the distortion limiter as illustrated in Figures 1-3.

The memory 508 may comprise a non-transient memory for storing code instructions executable by the processor(s) 506, specifically, a processor-readable memory comprising/storing non-transitory instructions that, when executed, cause a processor(s) to implement the operations and components of the distortion limiting method and distortion limiter as described in the present disclosure. The memory 508 may also comprise a random access memory or buffer(s) to store intermediate processing data from the various functions performed by the processor(s) 506.

Those of ordinary skill in the art will realize that the description of the distortion limiter and distortion limiting method is illustrative only and is not intended to be in any way limiting. Other embodiments will readily suggest themselves to such persons with ordinary skill in the art having the benefit of the present disclosure. Furthermore, the disclosed distortion limiter and distortion limiting method may be customized to offer valuable solutions to existing needs and problems of encoding and decoding sound.

In the interest of clarity, not all of the routine features of the implementations of the distortion limiter and distortion limiting method are shown and described. It will, of course, be appreciated that in the development of any such actual implementation of the distortion limiter and distortion limiting method, numerous implementation-specific decisions may need to be made in order to achieve the developer's specific goals, such as compliance with application-, system-, network- and business-related constraints, and that these specific goals will vary from one implementation to another and from one developer to another. Moreover, it will be appreciated that a development effort might be complex and time-consuming, but would nevertheless be a routine undertaking of engineering for those of ordinary skill in the field of sound processing having the benefit of the present disclosure.

In accordance with the present disclosure, the components/processors/modules, processing operations, and/or data structures described herein may be implemented using various types of operating systems, computing platforms, network devices, computer programs, and/or general purpose machines. In addition, those of ordinary skill in the art will recognize that devices of a less general purpose nature, such as hardwired devices, field programmable gate arrays (FPGAs), application specific integrated circuits (ASICs), or the like, may also be used. Where a method comprising a series of operations and sub-operations is implemented by a processor, computer or a machine and those operations and sub-operations may be stored as a series of non-transitory code instructions readable by the processor, computer or machine, they may be stored on a tangible and/or non-transient medium.

The distortion limiter and distortion limiting method as described herein may use software, firmware, hardware, or any combination(s) of software, firmware, or hardware suitable for the purposes described herein.

In the distortion limiter and distortion limiting method as described herein, the various operations and sub-operations may be performed in various orders and some of the operations and sub-operations may be optional.

Although the present disclosure has been described hereinabove by way of non-restrictive, illustrative embodiments thereof, these embodiments may be modified at will within the scope of the appended claims without departing from the scope of the present disclosure.

### References

The present disclosure mentions the following references:
[1] 3GPP TS 26.445, v.16.1.0, "Codec for Enhanced Voice Services (EVS); Detailed Algorithmic Description", July 2020.
[2] 3GPP SA4 contribution S4-170749 "New WID on EVS Codec Extension for Immersive Voice and Audio Services", SA4 meeting #94, June 26-30, 2017, http://www.3gpp.org/ftp/tsg_sa/WG4_CODEC/TSGS4_94/Docs/S4-170749.zip
[3] "Information Technology - Programming Languages - C", International Standard ISO/IEC 9899:1999.
[4] Luzheng Lu, "A digital realization of audio dynamic range control," ICSP '98. 1998 Fourth International Conference on Signal Processing (Cat. No.98TH8344), 1998, pp. 1424-1427 vol.2, doi: 10.1109/ICOSP.1998.770888.

## Claims

1. A two-stage distortion limiter (250) for limiting distortion in a sound signal, comprising:
- a first stage comprising:
a level detector (151) for detecting an amplitude value of the sound signal and for computing a control gain using the detected amplitude value;
an attenuator (155) of the level of the sound signal using the control gain; and
- a second stage comprising:
a saturation detector (251) for detecting saturation in the sound signal and for updating the control gain in response to detection of saturation.

2. The two-stage distortion limiter according to claim 1, wherein the sound signal is an output sound signal synthesis from a sound signal decoder.

3. The two-stage distortion limiter according to claim 1 or 2, wherein the detected amplitude value of the sound signal is a peak value of the sound signal.

4. The two-stage distortion limiter according to any one of claims 1 to 3, wherein the sound signal comprises a plurality of channels and wherein the two-stage distortion limiter is a two-stage multi-channel distortion limiter of which the first and second stages are applied to every channel of the sound signal.

5. The two-stage distortion limiter according to any one of claims 1 to 4, wherein the level detector compares the detected amplitude value with a sound signal limiter threshold to compute the control gain.

6. The two-stage distortion limiter according to claim 5, wherein, if the detected amplitude value is equal to or lower than the limiter threshold, the level detector sets the control gain to 1.

7. The two-stage distortion limiter according to claim 5 or 6, wherein, if the detected amplitude value is larger than the limiter threshold, the level detector selects the control gain as the larger of (a) a ratio between the detected amplitude value and the limiter threshold and (b) a lowest gain limit.

8. The two-stage distortion limiter according to any one of claims 1 to 7, wherein the first stage comprises a calculator of an attack/release time parameter defining a shorter or longer attack/release time depending on transient versus non-transient characteristics of the sound signal.

9. The two-stage distortion limiter according to claim 8, wherein the sound signal is formed of sound signal samples, and wherein the attenuator comprises:
a gain filter using the attack/release time parameter and the control gain to obtain a gain per sample of the sound signal; and
an amplifier for applying the gain per sample to the respective samples of the sound signal and obtain a distortion-limited sound signal.

10. The two-stage distortion limiter according to any one of claims 1 to 9, wherein the saturation detector comprises a first calculator of a saturation detection flag indicative of detection of saturation of the sound signal.

11. The two-stage distortion limiter according to claim 10, wherein the first calculator updates a saturation detection counter which stores a probability that saturation is present in a current sound signal processing frame.

12. The two-stage distortion limiter according to claim 11, wherein a sound signal decoder produces a parameter indicative of bit errors in a bitstream received by the sound signal decoder, and the first calculator updates the saturation detection counter to a maximum value thereof and sets the saturation detection flag to a saturation indicating value when the produced parameter indicates bit errors in the bitstream.

13. The two-stage distortion limiter according to claim 11, wherein the first calculator sets the saturation detection flag to a saturation indicating value when (a) a parameter produced by a sound signal decoder indicates no bit errors in a bitstream received by the sound signal decoder, and (b) the detected amplitude value is larger than a given threshold and the saturation detection counter is larger than 0.

14. The two-stage distortion limiter according to claim 11, wherein, if (a) a parameter produced by a sound signal decoder indicates no bit errors in a bitstream received by the sound signal decoder, (b) the detected amplitude value is not larger than a first given threshold and/or the saturation detection counter is not larger than 0, and (c) the detected amplitude value is larger than a second given threshold, the first calculator sets the saturation detection flag to a saturation indicating value and updates the saturation detection counter to the minimum between a maximum value of the saturation detection counter and the sum of the saturation detection counter and a constant.

15. The two-stage distortion limiter according to claim 11, wherein the first calculator sets the saturation detection flag to a saturation indicating value if (a) a parameter produced by a sound signal decoder indicates bit errors in a bitstream received by the sound signal decoder, (b) the detected amplitude value is larger than a first given threshold and the saturation detection counter is larger than 0, or (c) the detected amplitude value is larger than a second given threshold.

16. The two-stage distortion limiter according to claim 11, wherein the first calculator updates the saturation detection counter to the maximum between 0 and a difference between the saturation detection counter and a constant if (a) a parameter produced by a sound signal decoder indicates no bit errors in a bitstream received by the sound signal decoder, (b) the detected amplitude value is equal to or lower than a first given threshold and/or the saturation detection counter is equal to 0, and (c) the detected amplitude value is equal to or lower than a second given threshold.

17. The two-stage distortion limiter according to any one of claims 10 to 16, wherein the saturation detector comprises a second calculator responsive to the saturation detection flag equal to a saturation indicating value for updating the control gain.

18. The two-stage distortion limiter according to claim 17, wherein the second calculator calculates a gain correction factor as a function of the detected amplitude value and a sound signal limiter threshold, and uses the gain correction factor to update the control gain.

19. The two-stage distortion limiter according to claim 18, wherein the second calculator uses another, constant correction factor to update the control gain if the gain correction factor is lower than a certain threshold and performs no updating of the control gain if the gain correction factor is equal to or larger than the certain threshold.

20. A two-stage method for limiting distortion in a sound signal, comprising:
- in a first stage:
detecting an amplitude value of the sound signal and computing a control gain using the detected amplitude value;
attenuating the level of the sound signal using the control gain; and
- in a second stage:
detecting saturation in the sound signal and updating the control gain in response to detection of saturation.

21. The two-stage distortion limiting method according to claim 20, wherein the sound signal is an output sound signal synthesis from a sound signal decoder.

22. The two-stage distortion limiting method according to claim 20, wherein the detected amplitude value of the sound signal is a peak value of the sound signal.

23. The two-stage distortion limiting method according to any one of claims 20 to 22, wherein the sound signal comprises a plurality of channels and wherein the two-stage distortion limiting method is a two-stage multi-channel distortion limiting method of which the first and second stages are applied to every channel of the sound signal.

24. The two-stage distortion limiting method according to any one of claims 20 to 23, wherein detecting the sound signal amplitude value and computing the control gain comprises comparing the detected amplitude value with a sound signal limiter threshold to compute the control gain.

25. The two-stage distortion limiting method according to claim 24, wherein, if the detected amplitude value is equal to or lower than the limiter threshold, detecting the sound signal amplitude value and computing the control gain comprises setting the control gain to 1.

26. The two-stage distortion limiting method according to claim 24 or 25, wherein, if the detected amplitude value is larger than the limiter threshold, detecting the sound signal amplitude value and computing the control gain comprises selecting the control gain as the larger of (a) a ratio between the detected amplitude value and the limiter threshold and (b) a lowest gain limit.

27. The two-stage distortion limiting method according to any one of claims 20 to 26, comprising, in the first stage, calculating an attack/release time parameter defining a shorter or longer attack/release time depending on transient versus non-transient characteristics of the sound signal.

28. The two-stage distortion limiting method according to claim 27, wherein the sound signal is formed of sound signal samples, and wherein attenuating the level of the sound signal comprises:
gain filtering, using the attack/release time parameter and the control gain, to obtain a gain per sample of the sound signal; and
applying the gain per sample to the respective samples of the sound signal and obtain a distortion-limited sound signal.

29. The two-stage distortion limiting method according to any one of claims 20 to 28, wherein detecting saturation in the sound signal and updating the control gain comprises calculating a saturation detection flag indicative of detection of saturation of the sound signal.

30. The two-stage distortion limiting method according to claim 29, wherein calculating the saturation detection flag comprises updating a saturation detection counter which stores a probability that saturation is present in a current sound signal processing frame.

31. The two-stage distortion limiting method according to claim 30, wherein a sound signal decoder produces a parameter indicative of bit errors in a bitstream received by the sound signal decoder, and wherein calculating the saturation detection flag comprises updating the saturation detection counter to a maximum value thereof and setting the saturation detection flag to a saturation indicating value when the produced parameter indicates bit errors in the bitstream.

32. The two-stage distortion limiting method according to claim 30, wherein calculating the saturation detection flag comprises setting the saturation detection flag to a saturation indicating value when (a) a parameter produced by a sound signal decoder indicates no bit errors in a bitstream received by the sound signal decoder, and (b) the detected amplitude value is larger than a given threshold and the saturation detection counter is larger than 0.

33. The two-stage distortion limiting method according to claim 30, wherein, if (a) a parameter produced by a sound signal decoder indicates no bit errors in a bitstream received by the sound signal decoder, (b) the detected amplitude value is not larger than a first given threshold and/or the saturation detection counter is not larger than 0, and (c) the detected amplitude value is larger than a second given threshold, calculating the saturation detection flag comprises setting the saturation detection flag to a saturation indicating value and updating the saturation detection counter to the minimum between a maximum value of the saturation detection counter and the sum of the saturation detection counter and a constant.

34. The two-stage distortion limiting method according to claim 30, wherein calculating the saturation detection flag comprises setting the saturation detection flag to a saturation indicating value if (a) a parameter produced by a sound signal decoder indicates bit errors in a bitstream received by the sound signal decoder, (b) the detected amplitude value is larger than a first given threshold and the saturation detection counter is larger than 0, or (c) the detected amplitude value is larger than a second given threshold.

35. The two-stage distortion limiting method according to claim 30, wherein calculating the saturation detection flag comprises updating the saturation detection counter to the maximum between 0 and a difference between the saturation detection counter and a constant if (a) a parameter produced by a sound signal decoder indicates no bit errors in a bitstream received by the sound signal decoder, (b) the detected amplitude value is equal to or lower than a first given threshold and/or the saturation detection counter is equal to 0, and (c) the detected amplitude value is equal to or lower than a second given threshold.

36. The two-stage distortion limiting method according to any one of claims 29 to 35, wherein detecting saturation in the sound signal and updating the control gain comprises updating the control gain in response to the saturation detection flag equal to a saturation indicating value.

37. The two-stage distortion limiting method according to claim 36, wherein updating the control gain comprises calculating a gain correction factor as a function of the detected amplitude value and a sound signal limiter threshold, and using the gain correction factor to update the control gain.

38. The two-stage distortion limiting method according to claim 37, wherein updating the control gain comprises using another, constant correction factor to update the control gain if the gain correction factor is lower than a certain threshold, and wherein no updating of the control gain is performed if the gain correction factor is equal to or larger than the certain threshold.

## Patentansprüche

1. Zweistufiger Verzerrungsbegrenzer (250) zum Begrenzen von Verzerrung in einem Tonsignal, umfassend:
- eine erste Stufe, umfassend:
einen Pegeldetektor (151) zum Erkennen eines Amplitudenwerts des Tonsignals und zum Berechnen einer Steuerverstärkung unter Verwendung des erkannten Amplitudenwerts;
einen Abschwächer (155) für den Pegel des Tonsignals unter Verwendung der Steuerverstärkung; und
- eine zweite Stufe, umfassend:
einen Sättigungsdetektor (251) zum Erkennen einer Sättigung im Tonsignal und zum Aktualisieren der Steuerverstärkung als Reaktion auf das Erkennen einer Sättigung.

2. Zweistufiger Verzerrungsbegrenzer nach Anspruch 1, wobei das Tonsignal ein von einem Tonsignaldecoder synthetisiertes Ausgangstonsignal ist.

3. Zweistufiger Verzerrungsbegrenzer nach Anspruch 1 oder 2, wobei der erkannte Amplitudenwert des Tonsignals ein Spitzenwert des Tonsignals ist.

4. Zweistufiger Verzerrungsbegrenzer nach einem der Ansprüche 1 bis 3, wobei das Tonsignal mehrere Kanäle umfasst und wobei der zweistufige Verzerrungsbegrenzer ein zweistufiger Mehrkanal-Verzerrungsbegrenzer ist, dessen erste und zweite Stufe auf jeden Kanal des Tonsignals angewendet werden.

5. Zweistufiger Verzerrungsbegrenzer nach einem der Ansprüche 1 bis 4, wobei der Pegeldetektor den erkannten Amplitudenwert mit einem Tonsignal-Begrenzungsschwellenwert vergleicht, um die Steuerverstärkung zu berechnen.

6. Zweistufiger Verzerrungsbegrenzer nach Anspruch 5, wobei der Pegeldetektor, wenn der erkannte Amplitudenwert gleich oder kleiner als der Begrenzungsschwellenwert ist, die Steuerverstärkung auf 1 setzt.

7. Zweistufiger Verzerrungsbegrenzer nach Anspruch 5 oder 6, wobei der Pegeldetektor, wenn der erkannte Amplitudenwert größer als der Begrenzungsschwellenwert ist, die Steuerverstärkung als den größeren Wert aus (a) einem Verhältnis zwischen dem erkannten Amplitudenwert und dem Begrenzungsschwellenwert und (b) einer untersten Verstärkungsgrenze auswählt.

8. Zweistufiger Verzerrungsbegrenzer nach einem der Ansprüche 1 bis 7, wobei die erste Stufe einen Rechner für einen Attack-/Release-Zeitparameter umfasst, der je nach transienten bzw. nicht-transienten Eigenschaften des Tonsignals eine kürzere oder längere Attack-/Release-Zeit definiert.

9. Zweistufiger Verzerrungsbegrenzer nach Anspruch 8, wobei das Tonsignal aus Tonsignal-Abtastwerten gebildet ist und wobei der Abschwächer umfasst:
ein Verstärkungsfilter, das den Attack-/Release-Zeitparameter und die Steuerverstärkung verwendet, um eine Verstärkung pro Abtastwert des Tonsignals zu erhalten; und
einen Verstärker zum Anwenden der Verstärkung pro Abtastwert auf die jeweiligen Abtastwerte des Tonsignals und zum Erhalten eines verzerrungsbegrenzten Tonsignals.

10. Zweistufiger Verzerrungsbegrenzer nach einem der Ansprüche 1 bis 9, wobei der Sättigungsdetektor einen ersten Rechner für ein Sättigungserkennungsflag umfasst, das die Erkennung einer Sättigung des Tonsignals anzeigt.

11. Zweistufiger Verzerrungsbegrenzer nach Anspruch 10, wobei der erste Rechner einen Sättigungserkennungszähler aktualisiert, der eine Wahrscheinlichkeit speichert, dass in einem aktuellen Tonsignal-Verarbeitungsrahmen eine Sättigung vorliegt.

12. Zweistufiger Verzerrungsbegrenzer nach Anspruch 11, wobei ein Tonsignaldecoder einen Parameter erzeugt, der Bitfehler in einem vom Tonsignaldecoder empfangenen Bitstrom anzeigt, und der erste Rechner den Sättigungserkennungszähler auf dessen Maximalwert aktualisiert und das Sättigungserkennungsflag auf einen Sättigung anzeigenden Wert setzt, wenn der erzeugte Parameter Bitfehler im Bitstrom anzeigt.

13. Zweistufiger Verzerrungsbegrenzer nach Anspruch 11, wobei der erste Rechner das Sättigungserkennungsflag auf einen Sättigung anzeigenden Wert setzt, wenn (a) ein von einem Tonsignaldecoder erzeugter Parameter keine Bitfehler in einem vom Tonsignaldecoder empfangenen Bitstrom anzeigt und (b) der erkannte Amplitudenwert größer als ein vorgegebener Schwellenwert ist und der Sättigungserkennungszähler größer als 0 ist.

14. Zweistufiger Verzerrungsbegrenzer nach Anspruch 11, wobei, wenn (a) ein von einem Tonsignaldecoder erzeugter Parameter keine Bitfehler in einem vom Tonsignaldecoder empfangenen Bitstrom anzeigt, (b) der erkannte Amplitudenwert nicht größer als ein erster vorgegebener Schwellenwert ist und/oder der Sättigungserkennungszähler nicht größer als 0 ist, und (c) der erkannte Amplitudenwert größer als ein zweiter vorgegebener Schwellenwert ist, der erste Rechner das Sättigungserkennungsflag auf einen Sättigung anzeigenden Wert setzt und den Sättigungserkennungszähler auf den Minimalwert zwischen einem Maximalwert des Sättigungserkennungszählers und der Summe aus dem Sättigungserkennungszähler und einer Konstante aktualisiert.

15. Zweistufiger Verzerrungsbegrenzer nach Anspruch 11, wobei der erste Rechner das Sättigungserkennungsflag auf einen Sättigung anzeigenden Wert setzt, wenn (a) ein von einem Tonsignaldecoder erzeugter Parameter Bitfehler in einem vom Tonsignaldecoder empfangenen Bitstrom anzeigt, (b) der erkannte Amplitudenwert größer als ein erster vorgegebener Schwellenwert ist und der Sättigungserkennungszähler größer als 0 ist, oder (c) der erkannte Amplitudenwert größer als ein zweiter vorgegebener Schwellenwert ist.

16. Zweistufiger Verzerrungsbegrenzer nach Anspruch 11, wobei der erste Rechner den Sättigungserkennungszähler auf den Maximalwert zwischen 0 und der Differenz zwischen dem Sättigungserkennungszähler und einer Konstante aktualisiert, wenn (a) ein von einem Tonsignaldecoder erzeugter Parameter keine Bitfehler in einem vom Tonsignaldecoder empfangenen Bitstrom anzeigt, (b) der erkannte Amplitudenwert gleich oder kleiner als ein erster vorgegebener Schwellenwert ist und/oder der Sättigungserkennungszähler gleich 0 ist, und (c) der erkannte Amplitudenwert gleich oder kleiner als ein zweiter vorgegebener Schwellenwert ist.

17. Zweistufiger Verzerrungsbegrenzer nach einem der Ansprüche 10 bis 16, wobei der Sättigungsdetektor einen zweiten Rechner umfasst, der auf das Sättigungserkennungsflag, das einem Sättigung anzeigenden Wert entspricht, reagiert, um die Steuerverstärkung zu aktualisieren.

18. Zweistufiger Verzerrungsbegrenzer nach Anspruch 17, wobei der zweite Rechner einen Verstärkungskorrekturfaktor als Funktion des erkannten Amplitudenwerts und eines Tonsignal-Begrenzungsschwellenwerts berechnet und den Verstärkungskorrekturfaktor zur Aktualisierung der Steuerverstärkung verwendet.

19. Zweistufiger Verzerrungsbegrenzer nach Anspruch 18, wobei der zweite Rechner einen anderen, konstanten Korrekturfaktor verwendet, um die Steuerverstärkung zu aktualisieren, wenn der Verstärkungskorrekturfaktor unter einem bestimmten Schwellenwert liegt, und keine Aktualisierung der Steuerverstärkung durchführt, wenn der Verstärkungskorrekturfaktor gleich oder größer als der bestimmte Schwellenwert ist.

20. Zweistufiges Verfahren zur Begrenzung der Verzerrung in einem Tonsignal, umfassend:
- in einer ersten Stufe:
Erkennen eines Amplitudenwerts des Tonsignals und Berechnen einer Steuerverstärkung unter Verwendung des erkannten Amplitudenwerts;
Dämpfung des Pegels des Tonsignals unter Verwendung der Steuerverstärkung; und
- in einer zweiten Stufe:
Erkennen einer Sättigung im Tonsignal und Aktualisieren der Steuerverstärkung als Reaktion auf die Erkennung einer Sättigung.

21. Zweistufiges Verzerrungsbegrenzungsverfahren nach Anspruch 20, wobei das Tonsignal ein von einem Tonsignaldecoder synthetisiertes Ausgangstonsignal ist.

22. Zweistufiges Verzerrungsbegrenzungsverfahren nach Anspruch 20, wobei der erkannte Amplitudenwert des Tonsignals ein Spitzenwert des Tonsignals ist.

23. Zweistufiges Verzerrungsbegrenzungsverfahren nach einem der Ansprüche 20 bis 22, wobei das Tonsignal mehrere Kanäle umfasst und wobei das zweistufige Verzerrungsbegrenzungsverfahren ein zweistufiges Mehrkanal-Verzerrungsbegrenzungsverfahren ist, bei dem die erste und die zweite Stufe auf jeden Kanal des Tonsignals angewendet werden.

24. Zweistufiges Verzerrungsbegrenzungsverfahren nach einem der Ansprüche 20 bis 23, wobei das Erkennen des Tonsignal-Amplitudenwerts und das Berechnen der Steuerverstärkung das Vergleichen des erkannten Amplitudenwerts mit einem Tonsignal-Begrenzungsschwellenwert umfasst, um die Steuerverstärkung zu berechnen.

25. Zweistufiges Verzerrungsbegrenzungsverfahren nach Anspruch 24, wobei, falls der erkannte Amplitudenwert gleich oder kleiner als der Begrenzungsschwellenwert ist, das Erkennen des Tonsignal-Amplitudenwerts und das Berechnen der Steuerverstärkung das Einstellen der Steuerverstärkung auf 1 umfasst.

26. Zweistufiges Verzerrungsbegrenzungsverfahren nach Anspruch 24 oder 25, wobei, falls der erkannte Amplitudenwert größer als der Begrenzungsschwellenwert ist, das Erkennen des Tonsignal-Amplitudenwerts und das Berechnen der Steuerverstärkung das Auswählen der Steuerverstärkung als den größeren Wert aus (a) einem Verhältnis zwischen dem erkannten Amplitudenwert und dem Begrenzungsschwellenwert und (b) einer untersten Verstärkungsgrenze umfasst.

27. Zweistufiges Verzerrungsbegrenzungsverfahren nach einem der Ansprüche 20 bis 26, wobei in der ersten Stufe ein Attack-/Release-Zeitparameter berechnet wird, der je nach transienten bzw. nicht-transienten Eigenschaften des Tonsignals eine kürzere oder längere Attack-/Release-Zeit definiert.

28. Zweistufiges Verzerrungsbegrenzungsverfahren nach Anspruch 27, wobei das Tonsignal aus Tonsignal-Abtastwerten gebildet ist und wobei das Dämpfen des Pegels des Tonsignals umfasst:
Verstärkungsfiltern unter Verwendung des Attack-/Release-Zeitparameters und der Steuerverstärkung, um eine Verstärkung pro Abtastwert des Tonsignals zu erhalten; und
Anwenden der Verstärkung pro Abtastwert auf die jeweiligen Abtastwerte des Tonsignals, um ein verzerrungsbegrenztes Tonsignal zu erhalten.

29. Zweistufiges Verzerrungsbegrenzungsverfahren nach einem der Ansprüche 20 bis 28, wobei das Erkennen einer Sättigung im Tonsignal und das Aktualisieren der Steuerverstärkung das Berechnen eines Sättigungserkennungsflags umfasst, das die Erkennung einer Sättigung des Tonsignals anzeigt.

30. Zweistufiges Verzerrungsbegrenzungsverfahren nach Anspruch 29, wobei das Berechnen des Sättigungserkennungsflags das Aktualisieren eines Sättigungserkennungszählers umfasst, der eine Wahrscheinlichkeit speichert, dass in einem aktuellen Tonsignal-Verarbeitungsrahmen eine Sättigung vorliegt.

31. Zweistufiges Verzerrungsbegrenzungsverfahren nach Anspruch 30, wobei ein Tonsignaldecoder einen Parameter erzeugt, der Bitfehler in einem vom Tonsignaldecoder empfangenen Bitstrom anzeigt, und wobei das Berechnen des Sättigungserkennungsflags das Aktualisieren des Sättigungserkennungszählers auf dessen Maximalwert und das Setzen des Sättigungserkennungsflags auf einen Sättigung anzeigenden Wert umfasst, wenn der erzeugte Parameter Bitfehler im Bitstrom anzeigt.

32. Zweistufiges Verzerrungsbegrenzungsverfahren nach Anspruch 30, wobei die Berechnung des Sättigungserkennungsflags umfasst, das Sättigungserkennungsflag auf einen Sättigung anzeigenden Wert zu setzen, wenn (a) ein von einem Tonsignaldecoder erzeugter Parameter keine Bitfehler in einem vom Tonsignaldecoder empfangenen Bitstrom anzeigt und (b) der erkannte Amplitudenwert größer als ein vorgegebener Schwellenwert ist und der Sättigungserkennungszähler größer als 0 ist.

33. Zweistufiges Verzerrungsbegrenzungsverfahren nach Anspruch 30, wobei, wenn (a) ein von einem Tonsignaldecoder erzeugter Parameter keine Bitfehler in einem vom Tonsignaldecoder empfangenen Bitstrom anzeigt, (b) der erkannte Amplitudenwert nicht größer als ein erster vorgegebener Schwellenwert ist und/oder der Sättigungserkennungszähler nicht größer als 0 ist, und (c) der erkannte Amplitudenwert größer als ein zweiter vorgegebener Schwellenwert ist, die Berechnung des Sättigungserkennungsflags das Setzen des Sättigungserkennungsflags auf einen Sättigung anzeigenden Wert und das Aktualisieren des Sättigungserkennungszählers auf den Minimalwert zwischen einem Maximalwert des Sättigungserkennungszählers und der Summe aus dem Sättigungserkennungszähler und einer Konstante umfasst.

34. Zweistufiges Verzerrungsbegrenzungsverfahren nach Anspruch 30, wobei das Berechnen des Sättigungserkennungsflags das Setzen des Sättigungserkennungsflags auf einen Sättigung anzeigenden Wert umfasst, wenn (a) ein von einem Tonsignaldecoder erzeugter Parameter Bitfehler in einem vom Tonsignaldecoder empfangenen Bitstrom anzeigt, (b) der erkannte Amplitudenwert größer als ein erster vorgegebener Schwellenwert ist und der Sättigungserkennungszähler größer als 0 ist, oder (c) der erkannte Amplitudenwert größer als ein zweiter vorgegebener Schwellenwert ist.

35. Zweistufiges Verzerrungsbegrenzungsverfahren nach Anspruch 30, wobei das Berechnen des Sättigungserkennungsflags das Aktualisieren des Sättigungserkennungszählers auf den Maximalwert zwischen 0 und einer Differenz zwischen dem Sättigungserkennungszähler und einer Konstante umfasst, wenn (a) ein von einem Tonsignaldecoder erzeugter Parameter keine Bitfehler in einem vom Tonsignaldecoder empfangenen Bitstrom anzeigt, (b) der erkannte Amplitudenwert gleich oder kleiner als ein erster vorgegebener Schwellenwert ist und/oder der Sättigungserkennungszähler gleich 0 ist, und (c) der erkannte Amplitudenwert gleich oder kleiner als ein zweiter vorgegebener Schwellenwert ist.

36. Zweistufiges Verzerrungsbegrenzungsverfahren nach einem der Ansprüche 29 bis 35, wobei das Erkennen einer Sättigung im Tonsignal und das Aktualisieren der Steuerverstärkung das Aktualisieren der Steuerverstärkung in Reaktion auf ein Sättigungserkennungsflag mit einem Sättigung anzeigenden Wert umfasst.

37. Zweistufiges Verzerrungsbegrenzungsverfahren nach Anspruch 36, wobei das Aktualisieren der Steuerverstärkung das Berechnen eines Verstärkungskorrekturfaktors als Funktion des erkannten Amplitudenwerts und eines Tonsignal-Begrenzungsschwellenwerts sowie das Verwenden des Verstärkungskorrekturfaktors zum Aktualisieren der Steuerverstärkung umfasst.

38. Zweistufiges Verzerrungsbegrenzungsverfahren nach Anspruch 37, wobei das Aktualisieren der Steuerverstärkung das Verwenden eines anderen, konstanten Korrekturfaktors zum Aktualisieren der Steuerverstärkung umfasst, wenn der Verstärkungskorrekturfaktor unter einem bestimmten Schwellenwert liegt, und wobei keine Aktualisierung der Steuerverstärkung durchgeführt wird, wenn der Verstärkungskorrekturfaktor gleich oder größer als der bestimmte Schwellenwert ist.

## Revendications

1. Limiteur de distorsion à deux étages (250) destiné à limiter la distorsion dans un signal sonore, comprenant :
- un premier étage comprenant :
un détecteur de niveau (151) pour détecter une valeur d'amplitude du signal sonore et calculer un gain de commande à l'aide de la valeur d'amplitude détectée ;
un atténuateur (155) du niveau du signal sonore utilisant le gain de commande ; et
- un second étage comprenant :
un détecteur de saturation (251) pour détecter la saturation dans le signal sonore et pour mettre à jour le gain de commande en réponse à la détection de la saturation.

2. Limiteur de distorsion à deux étages selon la revendication 1, dans lequel le signal sonore est une synthèse de signal sonore de sortie provenant d'un décodeur de signal sonore.

3. Limiteur de distorsion à deux étages selon la revendication 1 ou 2, dans lequel la valeur d'amplitude détectée du signal sonore est une valeur de crête du signal sonore.

4. Limiteur de distorsion à deux étages selon l'une quelconque des revendications 1 à 3, dans lequel le signal sonore comprend une pluralité de canaux et dans lequel le limiteur de distorsion à deux étages est un limiteur de distorsion multicanal à deux étages, dont les premier et second étages sont appliqués à chaque canal du signal sonore.

5. Limiteur de distorsion à deux étages selon l'une quelconque des revendications 1 à 4, dans lequel le détecteur de niveau compare la valeur d'amplitude détectée à un seuil du limiteur de signal sonore afin de calculer le gain de commande.

6. Limiteur de distorsion à deux étages selon la revendication 5, dans lequel, si la valeur d'amplitude détectée est inférieure ou égale au seuil du limiteur, le détecteur de niveau règle le gain de commande à 1.

7. Limiteur de distorsion à deux étages selon la revendication 5 ou 6, dans lequel, si la valeur d'amplitude détectée est supérieure au seuil du limiteur, le détecteur de niveau sélectionne le gain de commande comme étant le plus grand parmi (a) un rapport entre la valeur d'amplitude détectée et le seuil du limiteur et (b) une limite de gain la plus basse.

8. Limiteur de distorsion à deux étages selon l'une quelconque des revendications 1 à 7, dans lequel le premier étage comprend un calculateur d'un paramètre de temps d'attaque/de relâchement définissant un temps d'attaque/de relâchement plus court ou plus long en fonction de caractéristiques transitoires ou non transitoires du signal sonore.

9. Limiteur de distorsion à deux étages selon la revendication 8, dans lequel le signal sonore est formé d'échantillons de signal sonore, et dans lequel l'atténuateur comprend :
un filtre de gain utilisant le paramètre de temps d'attaque/de relâchement et le gain de commande pour obtenir un gain par échantillon du signal sonore ; et
un amplificateur pour appliquer le gain par échantillon aux échantillons respectifs du signal sonore et obtenir un signal sonore à distorsion limitée.

10. Limiteur de distorsion à deux étages selon l'une quelconque des revendications 1 à 9, dans lequel le détecteur de saturation comprend un premier calculateur d'un indicateur de détection de saturation indicatif de la détection de la saturation du signal sonore.

11. Limiteur de distorsion à deux étages selon la revendication 10, dans lequel le premier calculateur met à jour un compteur de détection de saturation qui stocke une probabilité qu'une saturation soit présente dans une trame de traitement de signal sonore actuelle.

12. Limiteur de distorsion à deux étages selon la revendication 11, dans lequel un décodeur de signal sonore produit un paramètre indicatif d'erreurs de bit dans un flux binaire reçu par ledit décodeur de signal sonore, et le premier calculateur met à jour le compteur de détection de saturation à sa valeur maximale et règle l'indicateur de détection de saturation à une valeur indiquant une saturation lorsque le paramètre produit indique des erreurs de bit dans le flux binaire.

13. Limiteur de distorsion à deux étages selon la revendication 11, dans lequel le premier calculateur règle l'indicateur de détection de saturation à une valeur indiquant une saturation lorsque (a) un paramètre produit par un décodeur de signal sonore n'indique aucune erreur de bit dans un flux binaire reçu par ledit décodeur de signal sonore, et (b) la valeur d'amplitude détectée est supérieure à un seuil donné et le compteur de détection de saturation est supérieur à 0.

14. Limiteur de distorsion à deux étages selon la revendication 11, dans lequel, si (a) un paramètre produit par un décodeur de signal sonore n'indique aucune erreur de bit dans un flux binaire reçu par ledit décodeur de signal sonore, (b) la valeur d'amplitude détectée n'est pas supérieure à un premier seuil donné et/ou le compteur de détection de saturation n'est pas supérieur à 0, et (c) la valeur d'amplitude détectée est supérieure à un second seuil donné, le premier calculateur règle l'indicateur de détection de saturation à une valeur indiquant une saturation et met à jour le compteur de détection de saturation au minimum entre une valeur maximale du compteur de détection de saturation et la somme du compteur de détection de saturation et d'une constante.

15. Limiteur de distorsion à deux étages selon la revendication 11, dans lequel le premier calculateur règle l'indicateur de détection de saturation à une valeur indiquant une saturation si (a) un paramètre produit par un décodeur de signal sonore indique des erreurs de bit dans un flux binaire reçu par ledit décodeur de signal sonore, (b) la valeur d'amplitude détectée est supérieure à un premier seuil donné et le compteur de détection de saturation est supérieur à 0, ou (c) la valeur d'amplitude détectée est supérieure à un second seuil donné.

16. Limiteur de distorsion à deux étages selon la revendication 11, dans lequel le premier calculateur met à jour le compteur de détection de saturation au maximum entre 0 et une différence entre le compteur de détection de saturation et une constante si (a) un paramètre produit par un décodeur de signal sonore n'indique aucune erreur de bit dans un flux binaire reçu par ledit décodeur de signal sonore, (b) la valeur d'amplitude détectée est égale ou inférieure à un premier seuil donné et/ou le compteur de détection de saturation est égal à 0, et (c) la valeur d'amplitude détectée est égale ou inférieure à un second seuil donné.

17. Limiteur de distorsion à deux étages selon l'une quelconque des revendications 10 à 16, dans lequel le détecteur de saturation comprend un second calculateur configuré pour, en réponse à l'indicateur de détection de saturation égal à une valeur indiquant une saturation, mettre à jour le gain de commande.

18. Limiteur de distorsion à deux étages selon la revendication 17, dans lequel le second calculateur calcule un facteur de correction de gain en fonction de la valeur d'amplitude détectée et d'un seuil du limiteur de signal sonore, et utilise le facteur de correction de gain pour mettre à jour le gain de commande.

19. Limiteur de distorsion à deux étages selon la revendication 18, dans lequel le second calculateur utilise un autre facteur de correction constant pour mettre à jour le gain de commande si le facteur de correction de gain est inférieur à un certain seuil et n'effectue aucune mise à jour du gain de commande si le facteur de correction de gain est égal ou supérieur au certain seuil.

20. Procédé à deux étages destiné à limiter la distorsion dans un signal sonore, comprenant :
- dans un premier étage :
la détection d'une valeur d'amplitude du signal sonore et le calcul d'un gain de commande à l'aide de la valeur d'amplitude détectée ;
l'atténuation du niveau du signal sonore à l'aide du gain de commande ; et
- dans un second étage :
la détection d'une saturation dans le signal sonore et la mise à jour du gain de commande en réponse à la détection de la saturation.

21. Procédé de limitation de distorsion à deux étages selon la revendication 20, dans lequel le signal sonore est une synthèse de signal sonore de sortie provenant d'un décodeur de signal sonore.

22. Procédé de limitation de distorsion à deux étages selon la revendication 20, dans lequel la valeur d'amplitude détectée du signal sonore est une valeur de crête du signal sonore.

23. Procédé de limitation de distorsion à deux étages selon l'une quelconque des revendications 20 à 22, dans lequel le signal sonore comprend une pluralité de canaux et dans lequel le procédé de limitation de distorsion à deux étages est un procédé de limitation de distorsion multicanal à deux étages, dont les premier et second étages sont appliqués à chaque canal du signal sonore.

24. Procédé de limitation de distorsion à deux étages selon l'une quelconque des revendications 20 à 23, dans lequel la détection de la valeur d'amplitude de signal sonore et le calcul du gain de commande comprennent la comparaison de la valeur d'amplitude détectée avec un seuil de limiteur de signal sonore afin de calculer le gain de commande.

25. Procédé de limitation de distorsion à deux étages selon la revendication 24, dans lequel, si la valeur d'amplitude détectée est égale ou inférieure au seuil du limiteur, la détection de la valeur d'amplitude du signal sonore et le calcul du gain de commande comprennent le réglage du gain de commande à 1.

26. Procédé de limitation de distorsion à deux étages selon la revendication 24 ou 25, dans lequel, si la valeur d'amplitude détectée est supérieure au seuil du limiteur, la détection de la valeur d'amplitude du signal sonore et le calcul du gain de commande comprennent la sélection du gain de commande comme étant le plus grand parmi (a) un rapport entre la valeur d'amplitude détectée et le seuil du limiteur et (b) une limite de gain la plus basse.

27. Procédé de limitation de distorsion à deux étages selon l'une quelconque des revendications 20 à 26, comprenant, au premier étage, le calcul d'un paramètre de temps d'attaque/de relâchement définissant un temps d'attaque/de relâchement plus court ou plus long en fonction de caractéristiques transitoires ou non transitoires du signal sonore.

28. Procédé de limitation de distorsion à deux étages selon la revendication 27, dans lequel le signal sonore est formé d'échantillons de signal sonore, et dans lequel l'atténuation du niveau du signal sonore comprend :
le filtrage de gain, à l'aide du paramètre de temps d'attaque/de relâchement et du gain de commande, afin d'obtenir un gain par échantillon du signal sonore ; et
l'application du gain par échantillon aux échantillons respectifs du signal sonore et l'obtention d'un signal sonore à distorsion limitée.

29. Procédé de limitation de distorsion à deux étages selon l'une quelconque des revendications 20 à 28, dans lequel la détection de la saturation dans le signal sonore et la mise à jour du gain de commande comprennent le calcul d'un indicateur de détection de saturation indicatif de la détection d'une saturation du signal sonore.

30. Procédé de limitation de distorsion à deux étages selon la revendication 29, dans lequel le calcul de l'indicateur de détection de saturation comprend la mise à jour d'un compteur de détection de saturation qui stocke une probabilité qu'une saturation soit présente dans une trame de traitement de signal sonore actuelle.

31. Procédé de limitation de distorsion à deux étages selon la revendication 30, dans lequel un décodeur de signal sonore produit un paramètre indicatif d'erreurs de bit dans un flux binaire reçu par le décodeur de signal sonore, et dans lequel le calcul de l'indicateur de détection de saturation comprend la mise à jour du compteur de détection de saturation à sa valeur maximale et le réglage de l'indicateur de détection de saturation à une valeur indiquant une saturation lorsque le paramètre produit indique des erreurs de bit dans le flux binaire.

32. Procédé de limitation de distorsion à deux étages selon la revendication 30, dans lequel le calcul de l'indicateur de détection de saturation comprend le réglage de l'indicateur de détection de saturation à une valeur indiquant une saturation lorsque (a) un paramètre produit par un décodeur de signal sonore n'indique aucune erreur de bit dans un flux binaire reçu par ledit décodeur de signal sonore, et (b) la valeur d'amplitude détectée est supérieure à un seuil donné et le compteur de détection de saturation est supérieur à 0.

33. Procédé de limitation de distorsion à deux étages selon la revendication 30, dans lequel, si (a) un paramètre produit par un décodeur de signal sonore n'indique aucune erreur de bit dans un flux binaire reçu par ledit décodeur de signal sonore, (b) la valeur d'amplitude détectée n'est pas supérieure à un premier seuil donné et/ou le compteur de détection de saturation n'est pas supérieur à 0, et (c) la valeur d'amplitude détectée est supérieure à un second seuil donné, le calcul de l'indicateur de détection de saturation comprend le réglage de l'indicateur de détection de saturation à une valeur indiquant une saturation et la mise à jour du compteur de détection de saturation au minimum entre une valeur maximale du compteur de détection de saturation et la somme du compteur de détection de saturation et d'une constante.

34. Procédé de limitation de distorsion à deux étages selon la revendication 30, dans lequel le calcul de l'indicateur de détection de saturation comprend le réglage de l'indicateur de détection de saturation à une valeur indiquant une saturation si (a) un paramètre produit par un décodeur de signal sonore indique des erreurs de bit dans un flux binaire reçu par le décodeur de signal sonore, (b) la valeur d'amplitude détectée est supérieure à un premier seuil donné et le compteur de détection de saturation est supérieur à 0, ou (c) la valeur d'amplitude détectée est supérieure à un second seuil donné.

35. Procédé de limitation de distorsion à deux étages selon la revendication 30, dans lequel le calcul de l'indicateur de détection de saturation comprend la mise à jour du compteur de détection de saturation au maximum entre 0 et une différence entre le compteur de détection de saturation et une constante si (a) un paramètre produit par un décodeur de signal sonore n'indique aucune erreur de bit dans un flux binaire reçu par ledit décodeur de signal sonore, (b) la valeur d'amplitude détectée est égale ou inférieure à un premier seuil donné et/ou le compteur de détection de saturation est égal à 0, et (c) la valeur d'amplitude détectée est égale ou inférieure à un second seuil donné.

36. Procédé de limitation de distorsion à deux étages selon l'une quelconque des revendications 29 à 35, dans lequel la détection de la saturation dans le signal sonore et la mise à jour du gain de commande comprennent la mise à jour du gain de commande en réponse à l'indicateur de détection de saturation étant égal à une valeur indiquant une saturation.

37. Procédé de limitation de distorsion à deux étages selon la revendication 36, dans lequel la mise à jour du gain de commande comprend le calcul d'un facteur de correction de gain en fonction de la valeur d'amplitude détectée et d'un seuil du limiteur de signal sonore, et l'utilisation du facteur de correction de gain pour mettre à jour le gain de commande.

38. Procédé de limitation de distorsion à deux étages selon la revendication 37, dans lequel la mise à jour du gain de commande comprend l'utilisation d'un autre facteur de correction constant pour mettre à jour le gain de commande si le facteur de correction de gain est inférieur à un certain seuil, et dans lequel aucune mise à jour du gain de commande n'est effectuée si le facteur de correction de gain est égal ou supérieur au certain seuil.
